(19) Europäisches Patentamt
European Patent Office
Office européen des brevets

(11) **EP 1 168 379 A2**

(12) **EUROPEAN PATENT APPLICATION**

(43) Date of publication:
**02.01.2002 Bulletin 2002/01**

(51) Int Cl.[7]: **H01C 17/232**, H01C 7/00, H01C 17/075, H01L 21/02, H01L 21/768

(21) Application number: **01000260.8**

(22) Date of filing: **29.06.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **29.06.2000 US 214996**

(71) Applicant: **Texas Instruments Incorporated Dallas, Texas 75251 (US)**

(72) Inventors:
• **Steinmann, Philipp**
  **81667, Munich (DE)**
• **Jackson, Stuart M.**
  **Texas 75035, Frisco (US)**
• **Higgins, Robert M.**
  **Texas 75082, Richard (US)**

(74) Representative: **Holt, Michael**
  **Texas Instruments Ltd., EPD MS/13, 800 Pavilion Drive**
  **Northampton Business Park, Northampton NN4 7YL (GB)**

(54) **Method of fabricating a thin film resistor with predetermined temperature coefficient of resistance**

(57) A thin film resistor (60) having a low TCR (temperature coefficient of resistance) and a method for engineering the TCR of a material for a thin film resistor (60). The thin film resistor (60) comprises a material with a sheet resistance selected for low or zero TCR. In order to increase the sheet resistance, a thinner (e.g., 20-50Å) layer of material may be used for thin film resistor (60).

FIG. 3

EP 1 168 379 A2

**Description**

FIELD OF THE INVENTION

The invention is generally related to the field of thin film resistors in integrated circuits and more specifically to thin film resistors having improved temperature independence.

BACKGROUND OF THE INVENTION

Thin film resistors are utilized in electronic circuits in many important technological applications. The resistors may be part of an individual device, or may be part of a complex hybrid circuit or integrated circuit. Some specific examples of thin film resistors in integrated circuits are the resistive ladder network in an analog-to-digital converter, and current limiting and load resistors in emitter follower amplifiers.

Film resistors can comprise a variety of materials including tantalum nitride (TaN), silicon chromium (SiCr), and nickel chromium (NiCr). These resistor materials are generally evaporated or sputtered onto a substrate wafer at a metal interconnect level and subsequently patterned and etched. The thin film resistors require an electrical connection to be made to them. Thus, two mask layers are required. One, TFRES, is to form the resistor itself and the other, TFHEAD, is used to form the resistor "heads" or contact points of the resistor. Connection is made from an overlying metal interconnect layer to the resistor heads. The resistor heads are required to protect the resistor during the via etch needed to make contact between the overlying metal interconnect layer and the resistor. In addition to two masks, multiple deposition and dry/wet etch steps are required to incorporate the resistor.

After fabrication, thin film resistors are laser trimmed for accuracy. However, accurate trimming is not sufficient. Many devices, such as voltage regulators and data converters require temperature independent performance. The temperature coefficient of resistance (TCR) of current NiCr thin film resistors is on the order of 120 ppm/°C. Thus, a relatively small variation in temperature across a data converter, for example, could detune the device.

One prior art approach to achieving increased temperature independence combines resistors with positive and negative TCRs. N-type polysilicon resistors and p-type polysilicon resistors are combined to balance the TCR. Unfortunately, polysilicon resistors have the problems of poor reproducibility, poor tolerance, and nonlinear behavior from depletion effects compared to NiCr thin film resistors.

SUMMARY OF THE INVENTION

The invention provides a thin film resistor having a low TCR (temperature coefficient of resistance) and a method for engineering the TCR of a material for a thin film resistor. The thin film resistor comprises a material with a sheet resistance selected for low or zero TCR. For example, if NiCr is used for the thin film resistor, a sheet resistance on the order of 485 ohms/sq. results in a low TCR of 8 ppm/°C. In order to increase the sheet resistance, a thinner layer of material may be used. In one embodiment of the invention, a layer of NiCr having a thickness between 20 and 50 Å is used for the thin film resistor.

An advantage of the invention is providing a thin film resistor having increased temperature independence.

BRIEF DESCRIPTION OF THE DRAWINGS

The present invention will now be further described, by way of example, with reference to the preferred and exemplary embodiments illustrated in the figures of the accompanying drawings in which:

FIG. 1 is a graph of TCR in ppm/°C versus sheet resistance;
FIG. 2 is a graph of relative resistance versus temperature for various NiCr deposition times;
FIG. 3 is a cross-sectional diagram of an integrated circuit having a thin film resistor; and
FIGs. 4A-4C are cross-sectional diagrams of the integrated circuit of FIG. 3 at various stages of fabrication.

DETAILED DESCRIPTION OF THE EMBODIMENTS

The following description of the preferred embodiment is merely exemplary in nature and is in no way intended to limit the invention or its application or uses. The present invention discloses a process for manufacturing a thin film resistor having improved temperature independence.

Resistors with a low temperature coefficient of resistance (TCR) are important in many devices demanding temperature independent performance, such as voltage regulators and data converters. Table I below shows the degree of detuning for various data converters. As the TCR decreases, the temperature independence increases. For example, a 16 bit DAC requires a trim accuracy of 0.0015%. At a TCR Of 300 ppm/°C, a 0.05°C temperature variation across the device will detune the R/2R resistor ladder of the data converter. When the TCR is decreased to 30 ppm/°C, detuning does not occur until the temperature variation across the device reaches 0.5°C.

Table I.

| Data Converter Detuning | | | |
|---|---|---|---|
| | necessary trim accuracy | detuning temperature variation TCR=300 ppm/°C | detuning temperature variation TCR=30ppm/°C |
| 10-bit DAC | 0.02% | 0.7°C | 6.7°C |
| 12 bit DAC | 0.01% | 0.3°C | 3.3°C |
| 16-bit DAC | 0.0015% | 0.05°C | 0.5°C |

Current thin film resistors have a thickness greater than 200Å and a TCR of approximately 120 ppm/°C. For a 16-bit DAC, a temperature variation of 0.12°C across the device would cause the resistor ladder to become detuned. Accordingly, thin film resistors having a TCR of 0 +/- 10 ppm/°C are desired to maximize temperature independence.

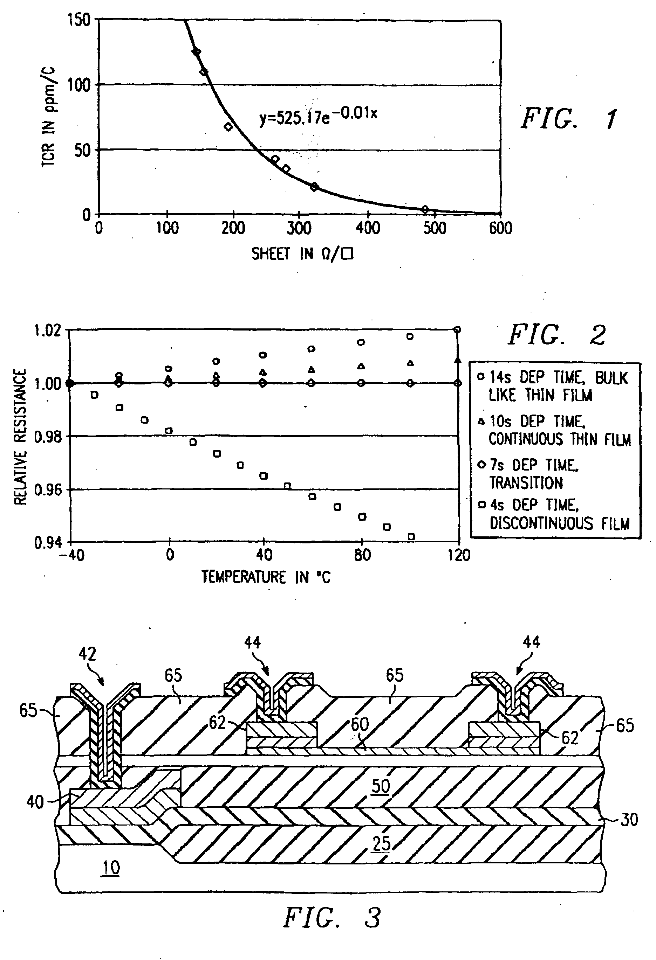

The inventors have observed that the TCR depends on the sheet resistance and therefore on the thickness of the thin film material layer. The TCR of 0 can be found for any of the thin film materials ($Ni_xCr_y$, $Si_xCr_y$, $Ta_xN_y$) by depositing the material with different thicknesses in the range from 20Å to 200Å and measuring the TCR for each thickness. The relationship between TCR and sheet resistance for the material can then be determined from the data. FIG 1 is a graph of experimental data illustrating the relationship between TCR and sheet resistance for a $Ni_{40}Cr_{60}$ film. The TCR of the thin film resistor material can be engineered by adjusting the sheet resistance. The sheet resistance can be adjusted to achieve not only low TCRs but also specific TCRs if desired. For example, using the experimental data from FIG. 1, the dependence of TCR on sheet resistance for $Ni_{40}Cr_{60}$ can be determined and expressed by the following equation:

$$TCR = 525.17 * exp(-0.01 * R_{sheet})$$

where: TCR is expressed in ppm/°C

$R_{sheet}$ is the sheet resistance expressed in Ohms/square

The relationship between TCR and sheet resistance can then be used to determine the necessary thickness for the specific material to achieve the desired TCR. This method of engineering the TCR can be applied to other materials such as other $Ni_xCr_{1-x}$ compositions with or without additional elements ($O_2$, $N_2$), SiCr or TaN using the above process.

Sheet resistance may be adjusted by decreasing the thin film thickness. A TCR of zero may be obtained using a $Ni_{40}Cr_{60}$ film having a thickness of 50 Å. FIG. 2 is a graph of relative resistance versus temperature for various $Ni_{40}Cr_{60}$ deposition times (and thus thicknesses). The deposition conditions were: Power 300W; Pressure 6000 mTorr, Temperature 200°C. A 4 second deposition time results in a discontinuous film with significant variation in resistance over the temperature range -40°C to 120°C. A 7 second deposition time, however, results in no variation in relative resistance over the temperature range. A 7 second deposition time would thus be a preferred deposition time to accomplish the invention of a thin film resistor with low TCR. A 10 second deposition time results in a 1% variation in resistance over the - 40 to 120 °C temperature range. As the deposition time is increased further, the variation in relative resistance increases. Other methods of adjusting the sheet resistance, such as using different material compositions or anneal strategies, will be apparent to those of ordinary skill in the art.

Various thin film transistors structures and methods of fabrication may be used to practice the invention. The following co-pending U.S. Patent Applications assigned to Texas Instruments Incorporated describe thin film transistor structures and methods of fabrication: Serial No: 60/156,291, filed September 23, 1999; Serial No: 60/156,292, filed September 23, 1999; Serial No: 60/208,705, filed June 1,2000; Serial No. 09/406,457 filed 27 September 1999; and serial no. 09/452,692 filed 2 December 1999. The instant invention may be incorporated into the above resistor structures and methods by adjusting the thickness of the thin film material to a thickness corresponding to the desired sheet resistance/TCR in the fashion described below.

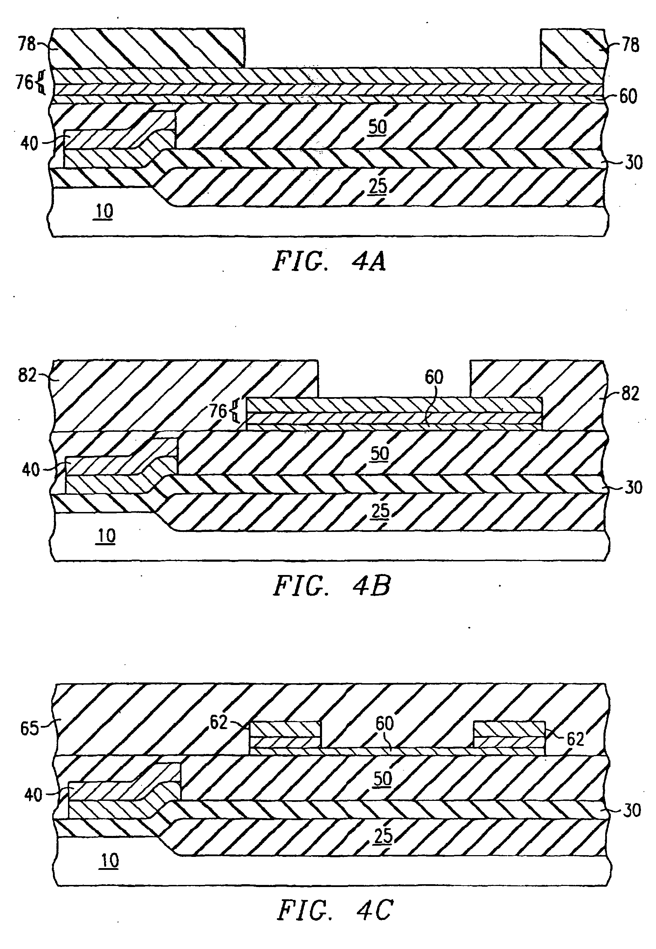

A thin film resistor 60 according to one embodiment of the invention is shown in FIG. 3. This embodiment is included for illustration purposes. The thin film resistor having low TCR according to the invention may be incorporated into a variety of thin film resistor structures and thin film resistor processes.

A first dielectric layer 30 is formed over a semiconductor body 10. Semiconductor body 10 may, for example, comprise a silicon substrate with transistors and other devices formed thereon. Semiconductor body 10 may also include an isolation structure such as field oxide 25 or shallow trench isolation. Thin film resistors are typically formed over the isolation regions 25 of a semiconductor body in order to allow laser trimming of the resistor.

Metal interconnect leads 40 are located over first dielectric layer 30. Metal interconnect leads 40 is shown as the first metal interconnect level, but may be part of the second or any subsequent metal interconnect layer except the upper most metal interconnect layer. Metal interconnect leads 40 may, for example, comprise aluminum with appropriate barrier layers. However, other suitable metals are known in the art.

Metal interconnect leads 40 are located within/under an interlevel dielectric (ILD) 50. ILD 50 may, for example, comprise a spin-on-glass. Other suitable dielectrics, such as HSQ (hydrogen silsesquioxane) or FSG (fluorine doped silicate glass), as well as combinations of dielectrics (e.g., combinations of TEOS, HDP oxide, and/or PSG), are known in the art.

Thin film resistor 60 is located over ILD 50 and preferably comprises nickel-chromium (NiCr). Other suitable thin film resistor materials are known in the art. For example, tantalum-nitride (TaN) or silicon chromium (SiCr) may alternatively be used. The thickness of thin film resistor is in the range of 20-50Å. In contrast, prior art thin film resistors had a thickness on the order of 200-2000Å. Reducing the thickness of the thin film resistor increases its sheet resistance and thus decreases the TCR. A thin film resistor having low or zero TCR is thus accomplished.

The TCR of the thin film resistor may be engineering by adjusting the sheet resistance (and thus the thickness) of the thin film material to obtain the desired TCR.

As shown in FIG. 3, resistor heads 62 are located at the ends of resistor 60. The resistor heads typically comprise a hard mask material such as aluminum over TiW.

Resistor 60 may be formed between two interconnect levels. Vias 44 extend from the upper interconnect level through interlevel dielectric 65 to resistor 60. Vias 42 extend through both interlevel dielectrics 65 and 50 to the lower interconnect level 40.

Alternatively, resistor 60 may be located at a metal interconnect level instead of between interconnect levels and/or vias may extend from resistor 60 to a lower interconnect level instead of an upper interconnect level. The placement of the resistor and connections to the resistor are not crucial to the invention. The key feature of the invention is the sheet resistance of the resistor material.

A method for forming thin film resistor 60 according to one embodiment of the invention will now be discussed with reference to FIGs. 4A-4C. Referring to Fig. 4A, a semiconductor body 10. Semiconductor body 10 is typically a silicon substrate processed through the formation of isolation structures, transistors, and other devices (not shown). Deposited over semiconductor body 10 is a dielectric layer 30. Dielectric layer 30 may be a PMD (poly-metal dielectric) layer if lower metal interconnect lines 40 are part of the first metal interconnect layer, sometimes referred to as Metal-1, as shown in FIG 4A. Alternatively, dielectric layer 30 may be an interlevel dielectric layer located between interconnect levels. In that case, metal interconnect lines 40 would be part of the second metal interconnect layer, sometimes referred to as METAL-2.

After the deposition, pattern, and etch to form metal interconnect leads 40, Interlevel dielectric (ILD) 50 is formed. ILD 50 is preferably a planarized layer and may be formed in any of a number of ways. Some examples include: deposition followed by CMP (chemical-mechanical-polishing), resist etch back, deposition of a flowable oxide such as HSQ, dep-etch-dep, deposition of a spin-on-glass (SOG) and etchback. Dielectric 50 may be any planarized dielectric suitable for interlevel dielectric layers, such as SOG, BPSG (boron and phosphorous doped silicate glass), PSG (phosphorous doped silicate glass), USG (undoped silicate glass) and HSQ.

Still referring to FIG. 4A, resistor material 60 is deposited over ILD 50. Resistor material 60 preferably comprises NiCr. Other suitable materials such as TaN and SiCr are known in the art. As an example, sputter deposition may be used. Resistor material 60 has a relatively high sheet resistance (e.g., on the order of 500 ohms/sq.) and may, for example, be 20-50Å thick.

Hardmask 76 is deposited over resistor material 60. Hardmask 76 preferably includes a layer of aluminum overlying a layer of TiW. As an example, the aluminum may be on the order of 2500Å thick and the TiW may be on the order of 1000Å thick. Alternative materials may be used for hardmask 76. However, these materials should be able to be dry etched with the resistor material 60 and wet etched selectively without removing resistor material 60.

Next, a photoresist mask 78 is formed over hardmask 76. The photoresist mask 78 covers those portions of hardmask 76 where resistor 60 and resistor heads 62 will be formed. The exposed portions of hardmask 76 and resistor material 62 are then removed using a dry etch, for examples $BCl_3$, $Cl_2$. The photoresist mask 78 is then removed.

A second photoresist mask 82 is formed over ILD 50 and hardmask 76, s shown in FIG. 4B. Second photoresist mask 82 exposes the portion of hardmask 76 where resistor 60 is desired but resistor heads 62 are not. The exposed portion of hardmask 76 is then wet etched leaving thin film resistor 60. Photoresist mask 82 is removed as shown in FIG. 4C.

Interlevel dielectric (ILD) 65 is formed over thin film resistor 60 and interlevel dielectric 50, as shown in FIG.

4C. Vias 42 and 44 are etched in ILD 65 with vias 42 extending through dielectric 50 as well. Vias 42 and 44 are filled with a conductive material such as aluminum with appropriate barriers or tungsten, as shown in FIG. 3. Vias 42 provide connection to various metal interconnect leads 40 and vias 44 provide connected to thin film resistor 60.

The process then continues with the formation of any desired subsequent metal interconnect levels. While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

**Claims**

1. A method of fabricating an integrated circuit comprising:

   forming a first interlevel dielectric over a substrate;
   forming a layer of resistor material over said first interlevel dielectric layer, said layer of resistor material having a TCR of 0 +/- 10 ppm/°C;
   patterning and etching said layer of resistor material to form a thin film resistor.

2. The method of claim 1, wherein said layer of resistor material has a thickness in the range of 20-50 Å.

3. The method of claim 1 or claim 2, wherein said layer of resistor material comprises $Ni_x Cr_{1-x}$.

4. The method of claim 3, wherein x equals 40.

5. The method of claim 1 or claim 2, wherein said layer of resistor material comprises SiCr.

6. The method of claim 1 or claim 2, wherein said layer of resistor material comprises TaN.

7. The method of any preceding claim, wherein said layer of resistor material has a sheet resistance on the order of 500 Ohms/sq.

8. The method of any of claims 1 to 3, or claim 7, wherein said step of forming said layer of resistor material comprises depositing NiCr for a deposition time in the range of 6-14 seconds.

9. The method of any of claims 1 to 3, or claims 7 to 8, wherein said step of forming said layer of resistor material comprises depositing NiCr for a deposition time of 7 seconds.

10. The method of any preceding claim, wherein a thickness of said layer of resistor material is selected using a process comprising the steps of:

    depositing structures of said resistor material on a test wafer at a plurality of different thicknesses in the range of 20Å-200Å;
    measuring the TCR for each of said thicknesses;
    determining a relationship between TCR and sheet thickness; and
    selecting a thickness corresponding to the TCR of 0 +/- 10 ppm/°C.

11. The method of claim 10, wherein, said resistor material comprises $Ni_{40}Cr_{60}$, and said relationship is

$$TCR = 525.17*exp(-0.01*R_{sheet})$$

    where: TCR is expressed in ppm/°C
    $R_{sheet}$ is the sheet resistance expressed in Ohms/square.

12. The method of claim 11, wherein said thickness is 50Å.

13. An integrated circuit, comprising:
    a thin film resistor having a thickness in the range of 20-50Å.

**14.** The integrated circuit of claim 13, wherein said thin film resistor comprises a material selected from the group consisting of NiCr, SiCr, and TaN.

**15.** The integrated circuit of claim 13 or claim 14, wherein said thin film resistor is located between two metal inter-connect levels.

FIG. 1

$y = 525.17e^{-0.01x}$

FIG. 2

○ 14s DEP TIME, BULK LIKE THIN FILM

▲ 10s DEP TIME, CONTINUOUS THIN FILM

◇ 7s DEP TIME, TRANSITION

□ 4s DEP TIME, DISCONTINUOUS FILM

FIG. 3

FIG. 4A

FIG. 4B

FIG. 4C